# EUROPEAN PATENT APPLICATION

(11) **EP 4 366 490 A1**
(43) Date of publication of application: **08.05.2024**
(21) Application number: 23206536.7
(22) Date of filing: 27.10.2023
(51) Int. Cl.: H10N 10/01, H10N 10/13, H10N 10/17, H10N 19/00

(54) **THERMOELECTRIC MODULE AND METHOD OF MANUFACTURE OR ASSEMBLY THEREOF**

(30) Priority: 01.11.2022 GR 20220100883; 15.12.2022 GB 202218930
(71) Applicant: European Thermodynamics Limited, Leicester, Leicestershire LE8 0RX (GB); Queen Mary University of London, London, Greater London E1 4NS (GB)
(72) Inventor: TULEY, Richard, Kibworth, LE8 0RX (GB); STEFANAKI, Eleni-Chrysanthi, Kibworth, LE8 0RX (GB); KOZ, Cevriye, Kibworth, LE8 0RX (GB); CHEN, Kan, London, E1 4NS (GB); WAN, Kening, Shanghai, 201805 (CN); KERNIN, Arnaud, London, NW6 5FS (GB); BILOTTI, Emiliano, London, SW7 2AZ (GB)
(74) Representative: Barker Brettell LLP

(57) **Abstract**

A net for a thermoelectric module, the net comprising:
an electrically insulating substrate;
a plurality of thermoelectric elements disposed on the substrate, the plurality of thermoelectric elements comprising one or more n-type thermoelectric elements and one or more p-type thermoelectric elements; and
one or more electrical interconnects disposed on the substrate, each electrical interconnect providing an electrical connection between a first thermoelectric element and a second thermoelectric element, wherein the first thermoelectric element is one of an n-type or a p-type thermoelectric element and the second thermoelectric element is the other of an n-type or a p-type thermoelectric element;
wherein the substrate comprises a single sheet of material with one or more fold lines extending at least partially across the substrate, wherein the one or more fold lines are arranged such that folding the substrate along the one or more fold lines forms an at least partially open network structure.

## Description

The present disclosure relates to thermoelectric devices, in particular thermoelectric devices for energy generation. In particular, the disclosure relates to a thermoelectric generator and a method of making such a thermoelectric generator.

Many electrical systems, such as sensors, may be in positions where it is not convenient or economically viable to power them by means of hard wiring them to a central power source such as the electrical grid. For example, if the electrical system is in a remote or inaccessible location or is required to be mobile, mains power is not available. Typically, such electrical systems may be powered by batteries. However, batteries are limited by the total stored charge, and therefore access to the electrical system is needed to replace the batteries. Such access can be challenging, unsafe and/or expensive, therefore making the systems difficult to maintain.

Moreover, the need to frequently replace batteries can be expensive and is not environmentally friendly. The need to have sufficient replacement batteries available can also be detrimental if space and/or weight is at a premium.

One solution to these problems is to have an energy generation device associated with the electrical system, so that it can be electrically self-sufficient (so-called "fit-and-forget") and/or to increase the lifetime of a battery. For example, the energy generation device may re-charge one or more batteries.

A thermoelectric generator is an example of such an energy generating device and can be used wherever there is a temperature difference. For example, a thermoelectric generator can operate using the temperature difference between a hot pipe or surface and the ambient air temperature.

Generally, the temperature differences available are often small, and so a standard thermoelectric generator device may produce sufficient power, but at a very low voltage. The low voltages can be difficult to interface efficiently with the required electrical system. There is therefore a need to create thermoelectric generators capable of producing sufficiently high voltages even at low temperature differences.

To achieve a high voltage at low temperature differences, a large number of thermoelectric elements (e.g., semiconductors) need to be connected electrically in series. Standard thermoelectric devices have a lower limit on the cross-sectional area of the thermoelectric elements perpendicular to the temperature gradient due to the requirements of mechanical stability, and minimum size for sufficient yield in cutting and assembly. Therefore, in a standard thermoelectric generator device a large number of thermoelectric elements may result in a large and costly device.

An alternative method to produce a large number of thermoelectric elements is to have the thermoelectric elements disposed on a substrate, with a temperature gradient parallel to the substrate. This allows the use of a much smaller cross section of a thermoelectric element perpendicular to the temperature gradient; as for example the substrate support may provide mechanical support, ease of handling and easier thermoelectric element formation. In order to then achieve the required number of thermoelectric elements, the substrates can be stacked or layered in a compact or low-cost manner.

There are a number of ways to layer these substrates, including rolling (e.g., as shown in EP3109910B1) or folding (e.g., as shown in EP2862208B1). However, when either the hot or cold side of the device is thermally connected to hot or cold air, the thermal coupling between the air and the device is often weak, so that a large proportion of the total temperature drop occurs across between the air and the thermoelectric material. Since output power is increased with a higher temperature difference across the thermoelectric material, it is desirable to decrease the proportion of the total temperature difference that is dropped between the air and the thermoelectric material. Conventionally, a heat sink is utilised to increase the surface area for the thermal coupling between the thermoelectric device and the air. However, a heat sink adds significant weight and cost, and often it is the heat sink itself that dominates the overall size. An aim of the present disclosure is to provide a thermoelectric device with good thermal coupling to air compared to the thermal resistance of the thermoelectric elements to avoid the need for a heat sink.

Nanoscale, 2019,11, 17725-17735 shows an approach to make a honeycomb structured thermoelectric device by bonding multiple strips together.

US201102201631 shows an example of folding and cutting to create a thermoelectric device.

US35541815 shows a two-sided thermoelectric device that can be rolled up.

WO2019190120A1 shows elongated electrical interconnects which may allow the interconnects to act as a heat sink to air.

In order to ensure good thermal coupling to air, the surface area for interaction with air may be made significantly larger than the cross-sectional area of the thermoelectric material perpendicular to the direction of the heat flow. However, in many applications the airflow velocity will be low, or even solely reliant on natural convection. To get good heat transfer at low airflow velocities or natural convection, the spacing between the surfaces interacting with the air must be significantly larger than typical substrate thicknesses. Therefore, to avoid an additional heat sink, a more spaced-out device is required rather than a tightly folded or rolled design. An example of a mechanically stable, more spaced out or distributed design would be if the substrate forms a hexagonal or honeycomb pattern. While Nanoscale, 2019,11, 17725-17735 shows a method to make such a device by joining multiple strips together, in this disclosure we demonstrate how to form a hexagonal thermoelectric device from a single substrate. This results in easier assembly, with a more scalable thermoelectric device with the potential for lower cost.

A first aspect provides a net for a thermoelectric module, the net comprising:
an electrically insulating substrate;
a plurality of thermoelectric elements disposed on the substrate, the plurality of thermoelectric elements comprising one or more n-type thermoelectric elements and one or more p-type thermoelectric elements; and
one or more electrical interconnects disposed on the substrate, each electrical interconnect providing an electrical connection between a first thermoelectric element and a second thermoelectric element, wherein the first thermoelectric element is one of an n-type or a p-type thermoelectric element and the second thermoelectric element is the other of an n-type or a p-type thermoelectric element;
wherein the substrate comprises a single sheet of material with one or more fold lines extending at least partially across the substrate, wherein the one or more fold lines are arranged such that folding the substrate along the one or more fold lines forms an at least partially open network structure.

The one or more fold lines of the net may divide the substrate into two or more facets.

The at least partially open network structure may have one or more cells. The or each cell may have any shape. For example, one or more of the cells may be circular, triangular, square, rectangular, pentagonal, hexagonal, octagonal or dodecagonal.

The at least partially open network structure may comprise a honeycomb or hexagonal pattern.

The at least partially open network structure may comprise a pattern of tessellating shapes.

The substrate may comprise at least one aperture therethrough, the aperture(s) being arranged to facilitate folding of the substrate. One or more of the apertures may be located in a central portion of the substrate. One or more of the apertures may have the form of a slit.

The net may comprise one or more fin structures comprising a thermally conductive material. Each of the fin structures may form part of a different facet of the one or more cells. For example, the plurality of fin structures may form part of alternate facets of the one or more cells. Alternatively or in addition, the plurality of fin structures may form part of at least 50%, 33%, or 25% of the facets of the one or more cells. Alternatively or in addition, the plurality of fin structures may form part of less than or equal to 50%, 67%, or 75% of the facets of the one or more cells.

At least one of the fin structures, e.g. all of the fin structures, may comprise a portion of the substrate with the thermally conductive material disposed thereon.

At least one of the fin structures may be configured such that the fin structure(s) is/are disposed at least partially within a cell of the at least partially open network structure when the substrate is folded along the one or more fold lines.

One or more of the fin structures may comprise an extended portion of an electrical interconnect.

When the net is unfolded, one or more of the fin structures may lie within the or an aperture.

One or more of the thermoelectric elements may be disposed on a first side of the substrate. Alternatively or in addition, one or more of the thermoelectric elements may be disposed on a second side of the substrate opposite the first side of the substrate.

In an implementation, the p-type thermoelectric elements may be disposed on the first side of the substrate and the n-type thermoelectric elements may be disposed on the second side of the substrate or *vice versa.*

In an implementation having one or more thermoelectric elements disposed on the first side of the substrate and one or more thermoelectric elements disposed the second side of the substrate, one or more of the electrical interconnects may include: a first portion on the first side or the second side of the substrate; a second portion on the other of the first side or the second side of the substrate; and an intermediate portion connecting the first portion to the second portion. The intermediate portion may pass through the thickness of the substrate. The intermediate portion may extend through an aperture through the thickness of the substrate. Each of the first portion(s) or each of the second portion(s) of the electrical interconnects may extend across a fold line of the one or more fold lines.

One or more of the thermoelectric elements may comprise a thermoelectric material selected from one or more of the following: carbon nanotubes; a bismuth telluride (BiTe) based alloy such as BiTeSe or BiSbTe of various stoichiometries.

The net may comprise at least one bending strip extending across at least one of the fold lines. The bending strip(s) may be configured to change conformation in response to a stimulus, thereby causing the substrate to fold. One or more of the bending strips may comprise, or consist essentially of, bi-stretched polystyrene (b-PS). For instance, the stimulus may be heat.

One or more of the fold lines may take the form of perforations, indentations, or markings on or in the substrate, to indicate where to fold the substrate and/or to increase ease of folding.

A second aspect provides a thermoelectric module comprising:
an electrically insulating substrate;
a plurality of thermoelectric elements disposed on the substrate, the plurality of thermoelectric elements comprising one or more n-type thermoelectric elements and one or more p-type thermoelectric elements; and
one or more electrical interconnects disposed on the substrate, each electrical interconnect providing an electrical connection between a first thermoelectric element and a second thermoelectric element, wherein the first thermoelectric element is one of an n-type or a p-type thermoelectric element and the second thermoelectric element is the other of an n-type or a p-type thermoelectric element;
wherein the substrate comprises a single sheet of material with one or more fold lines extending at least partially across the substrate and the substrate is folded along the one or more fold lines to provide an at least partially open network structure.

The one or more fold lines of the net may divide the substrate into two or more facets.

The at least partially open network structure may have one or more cells. The or each cell may have any shape. For example, one or more of the cells may be circular, triangular, square, rectangular, pentagonal hexagonal, octagonal or dodecagonal.

The at least partially open network structure may comprise a honeycomb or hexagonal pattern.

The at least partially open network structure may comprise a pattern of tessellating shapes.

The thermoelectric module may comprise one or more fin structures comprising a thermally conductive material.

In an implementation, the thermoelectric module may comprise at least one fin structure comprising a thermally conductive material.

In an implementation, the thermoelectric module may comprise a plurality of fin structures each form part of a different facet of the one or more cells. For example, the plurality of fin structures may form part of alternate facets of the one or more cells. Alternatively or in addition, the plurality of fin structures may form part of at least 50%, 33%, or 25% of the facets of the one or more cells. Alternatively or in addition, the plurality of fin structures may form part of less than or equal to 50%, 67%, or 75% of the facets of the one or more cells.

At least one of the fin structures, e.g. all of the fin structures, may comprise a portion of the substrate with the thermally conductive material disposed thereon.

At least one of the fin structures comprising a thermally conductive material may be disposed at least partially within a cell of the at least partially open network structure.

In an implementation, one or more of the fin structures may comprise an extended portion of an electrical interconnect.

At least one of the fin structures may extend in a direction away from a base edge of the substrate.

In an implementation, the or a base edge of the folded substate may be in contact, in use, with a solid hot surface. The remaining edges and surfaces of the folded substrate may be in contact, in use, with cooler air.

In an implementation, the or a base edge of the folded substrate may be in contact, in use, with a solid cold surface. The remaining edges and surfaces of the folded substrate may be in contact, in use, with warmer air.

One or more of the thermoelectric elements may be disposed on a first side of the substrate. Alternatively or in addition, one or more of the thermoelectric elements may be disposed on a second side of the substrate opposite the first side of the substrate.

In an implementation, the p-type thermoelectric elements may be disposed on the first side of the substrate and the n-type thermoelectric elements may be disposed on the second side of the substrate or *vice versa.*

In an implementation having one or more thermoelectric elements disposed on the first side of the substrate and one or more thermoelectric elements disposed the second side of the substrate, one or more of the electrical interconnects may include: a first portion on the first side or the second side of the substrate; a second portion on the other of the first side or the second side of the substrate; and an intermediate portion connecting the first portion to the second portion. The intermediate portion may pass through the thickness of the substrate. The intermediate portion may extend through an aperture through the thickness of the substrate. Each of the first portion(s) or each of the second portion(s) of the electrical interconnects may extend across a fold line of the one or more fold lines.

One or more of the thermoelectric elements may comprise a thermoelectric material selected from one or more of the following: carbon nanotubes; a bismuth telluride (BiTe) based alloy such as BiTeSe or BiSbTe of various stoichiometries.

The thermoelectric module may comprise at least one bending strip extending across at least one of the fold lines. The bending strip(s) may be configured to change conformation in response to a stimulus, thereby causing the substrate to fold. One or more of the bending strips may comprise, or consist essentially of, bi-stretched polystyrene (b-PS). For instance, the stimulus may be heat.

One or more of the fold lines may take the form of perforations, indentations, or markings on or in the substrate, to indicate where to fold the substrate and/or to increase ease of folding.

A third aspect provides a thermoelectric device comprising at least one thermoelectric module according to the second aspect.

The thermoelectric device may comprise a thermoelectric generator or a thermoelectric cooler or heater.

A fourth aspect provides a method of manufacture or assembly of a thermoelectric module comprising:
providing a net according to the first aspect; and
folding the substrate along the one or more fold lines to form an at least partially open network structure.

Folding the substrate along the one or more fold lines may comprise applying a stimulus to one or more bending strips extending across at least one of the fold lines, wherein the bending strip is configured to change conformation in response to the stimulus.

A fifth aspect provides a use of a thermoelectric device according to the third aspect to generate electricity.

A sixth aspect provides a use of a thermoelectric device according to the third aspect to provide cooling or heating.

The skilled person will appreciate that except where mutually exclusive, any feature described herein may be applied to any aspect and/or combined with any other feature described herein within the scope of the invention as set of in the claims.

Examples are described below with reference to the accompanying drawings, in which:
Figure 1a shows a plan view of a net for a thermoelectric module.
Figure 1b shows a side cross-section of the net of Figure 1a.
Figure 1c shows a plan view of the net of Figure 1a, showing the fold lines;
Figure 2a shows a perspective view of a thermoelectric module formed from the net of
Figures 1a, 1b and 1c;

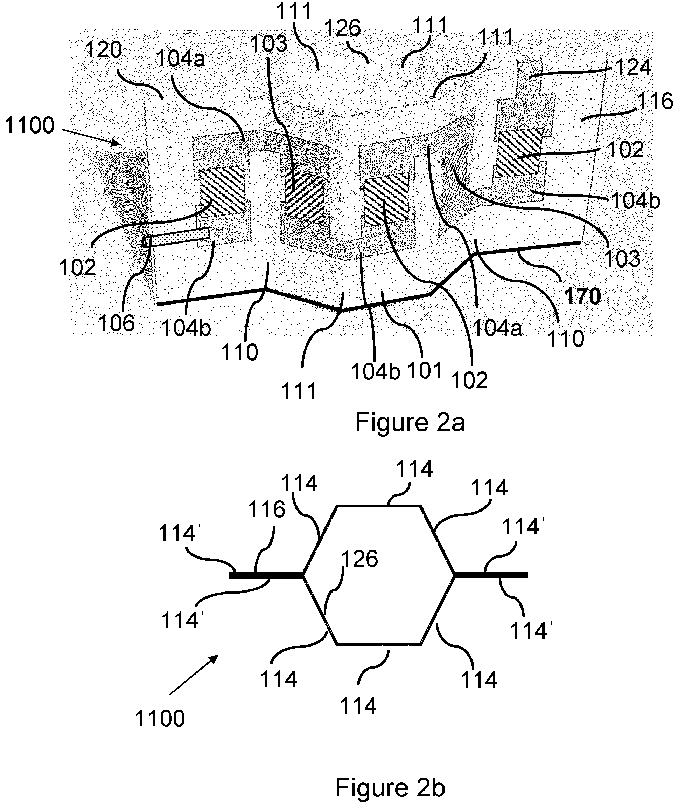

Figure 2b shows a plan view of the thermoelectric module of Figure 2a;

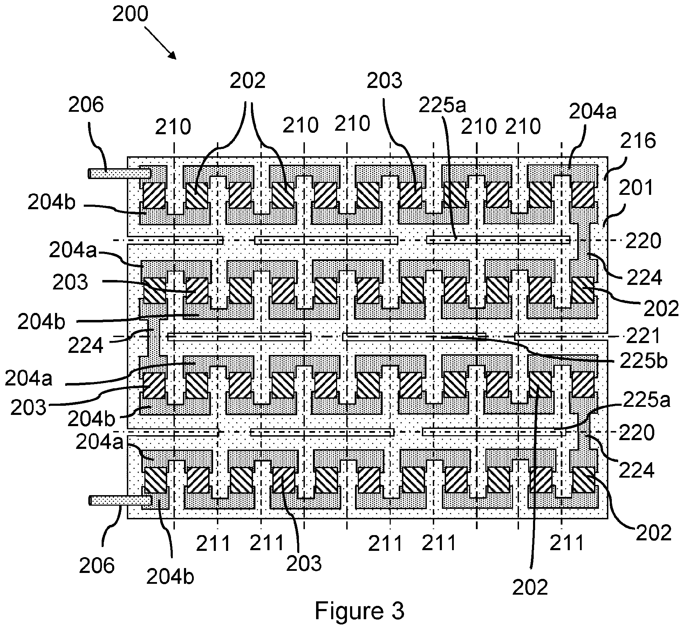

Figure 3 shows a plan view of another net for a thermoelectric module;

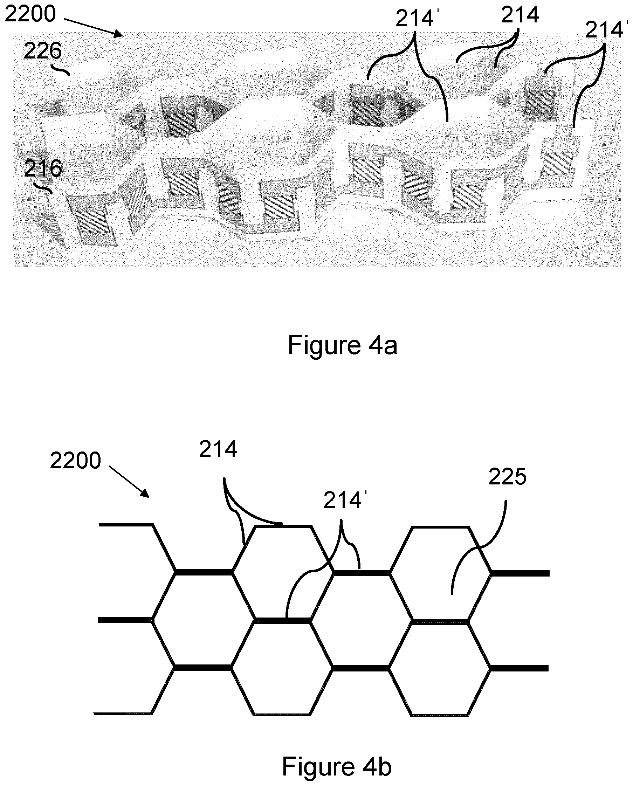

Figure 4a shows a perspective view of a thermoelectric module formed from the net of Figure 3;
Figure 4b shows a plan view of the thermoelectric module of Figure 4a;

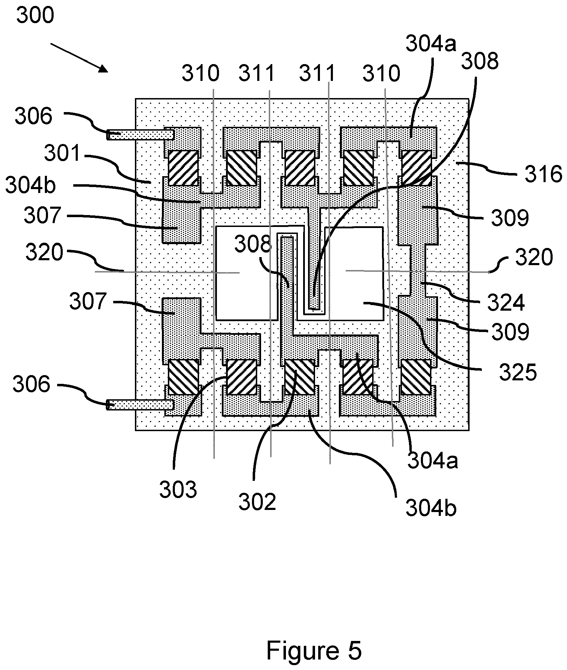

Figure 5 shows a plan view of another net for a thermoelectric;

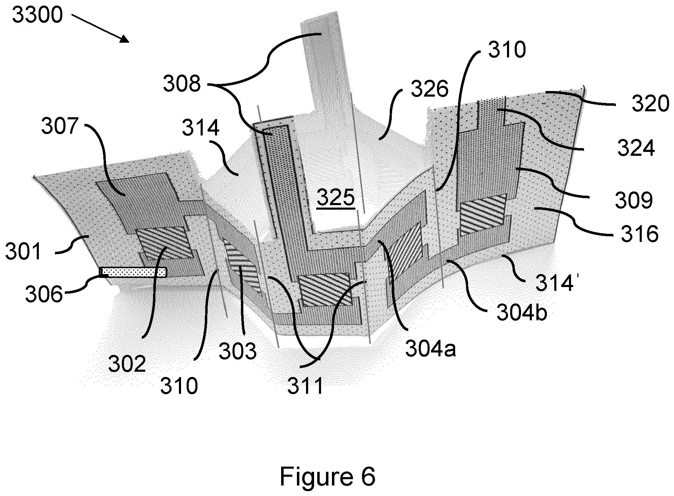

Figure 6 shows a perspective view of a thermoelectric module formed from the net of Figure 5;

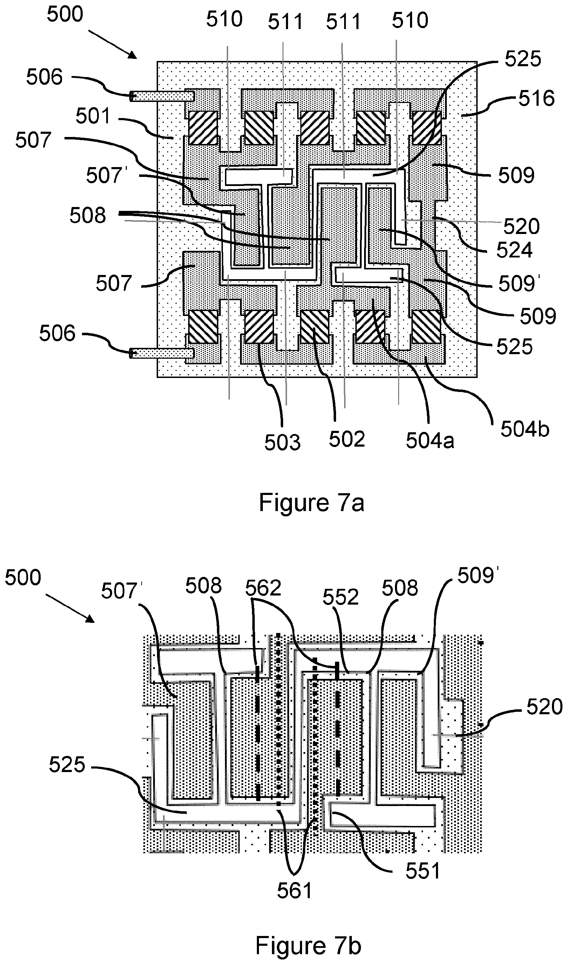

Figure 7a shows a plan view of another net for a thermoelectric module;
Figure 7b shows part of the net of Figure 7a;

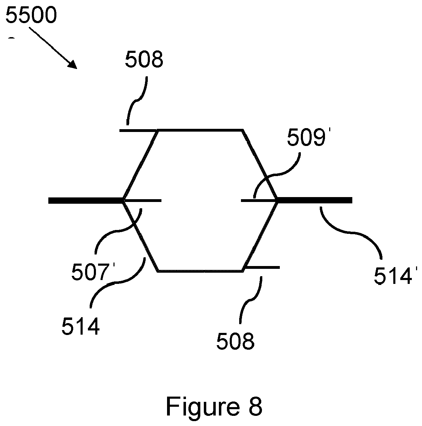

Figure 8 shows a plan view of a thermoelectric module formed from the net of Figure 7a;

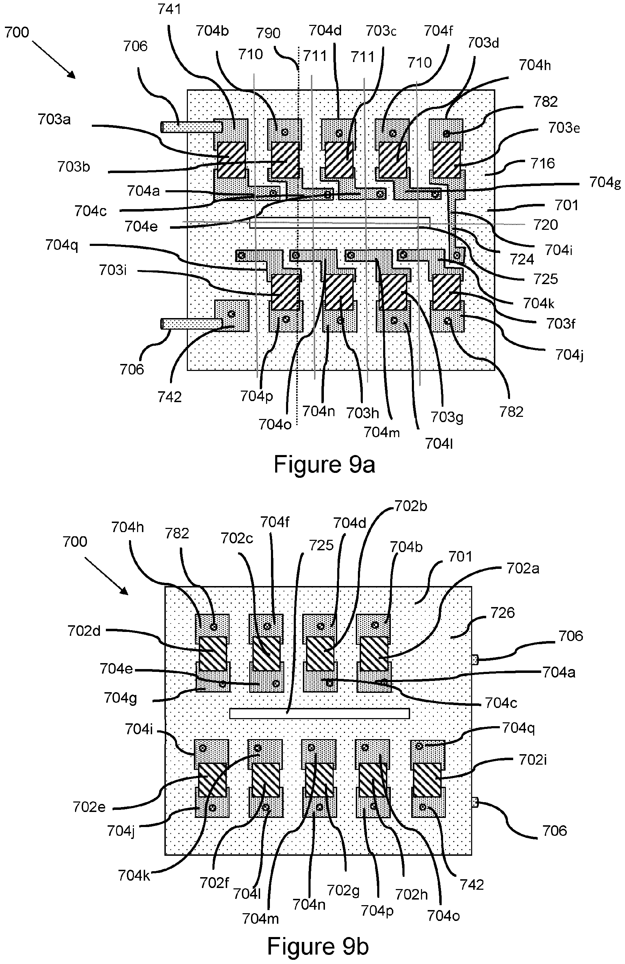

Figure 9a shows a plan view of another net for a thermoelectric module, showing a first side of the substrate;
Figure 9b shows a plan view of the net of Figure 9a, showing a second side of the substrate;

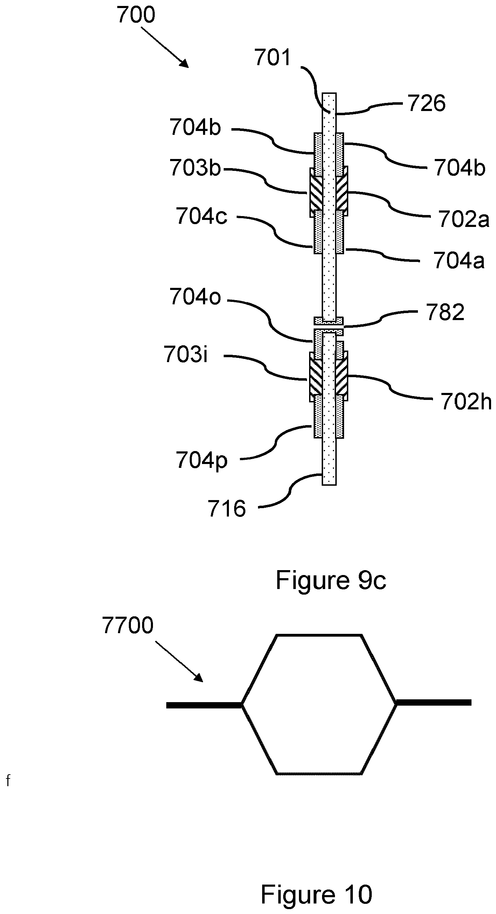

Figure 9c shows a cross-section of the net of Figures 9a and 9b;
Figure 10 shows a plan view of a thermoelectric module formed from the net of Figures 9a, 9b and 9c;

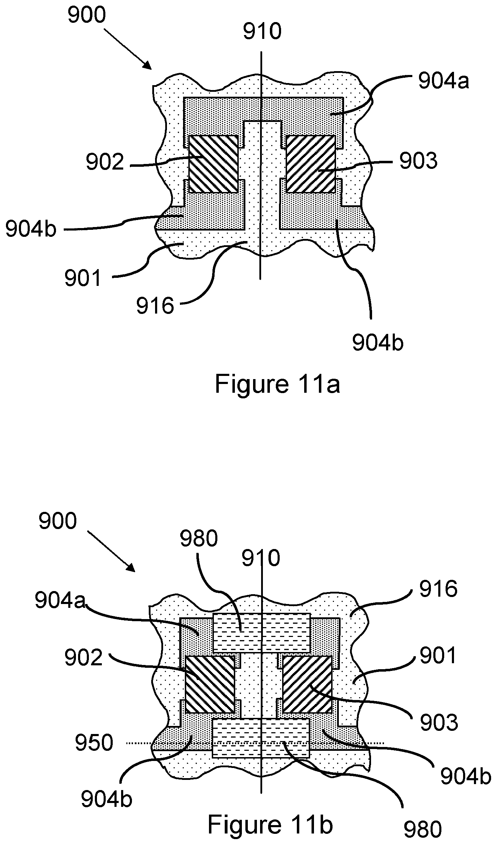

Figure 11a shows part of another net for a thermoelectric module;
Figure 11b shows the part of the net of Figure 11a with bending strips in place;

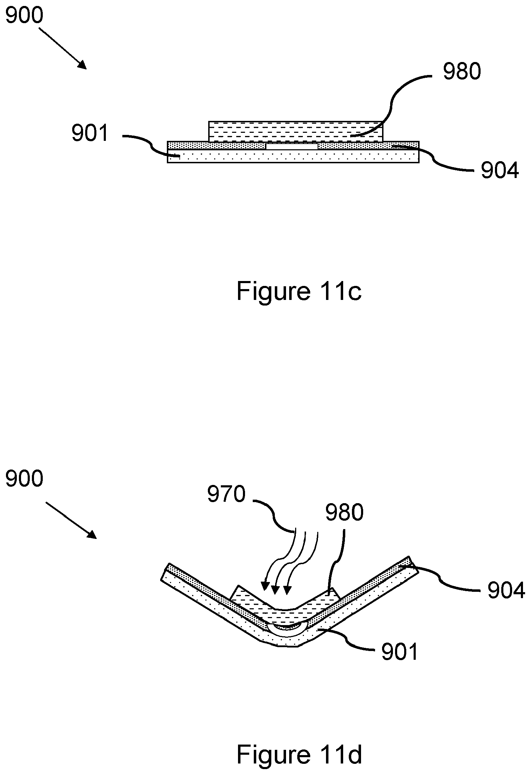

Figure 11c shows a cross section through the net of Figure 11b;
Figure 11d shows the cross section of Figure 11c following heating; and

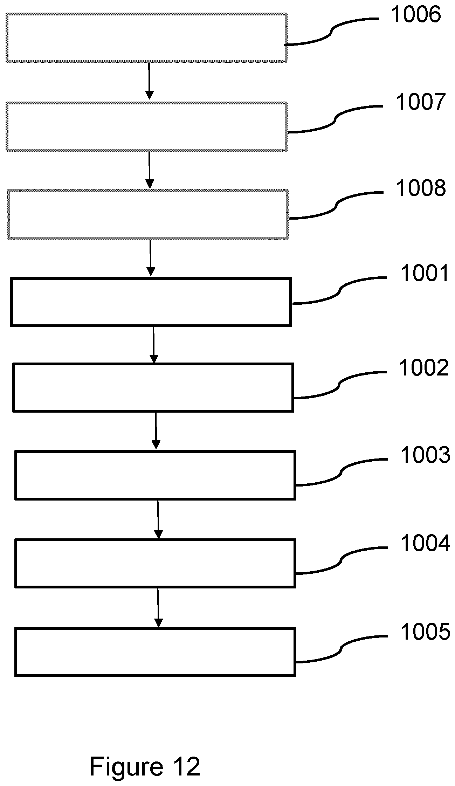

Figure 12 shows schematically a method of manufacture of a thermoelectric module.

As used herein, the term net is used to designate a structure that is foldable along one or more fold lines, such that at least a portion of its edges directly contact one another or at least a portion of its surfaces substantially face one another, to form a three-dimensional (3D) structure. The nets described herein may be configured such that at least a portion of its surfaces directly contact one another to form a three-dimensional (3D) structure.

The 3D structure may or may not be completely enclosed.

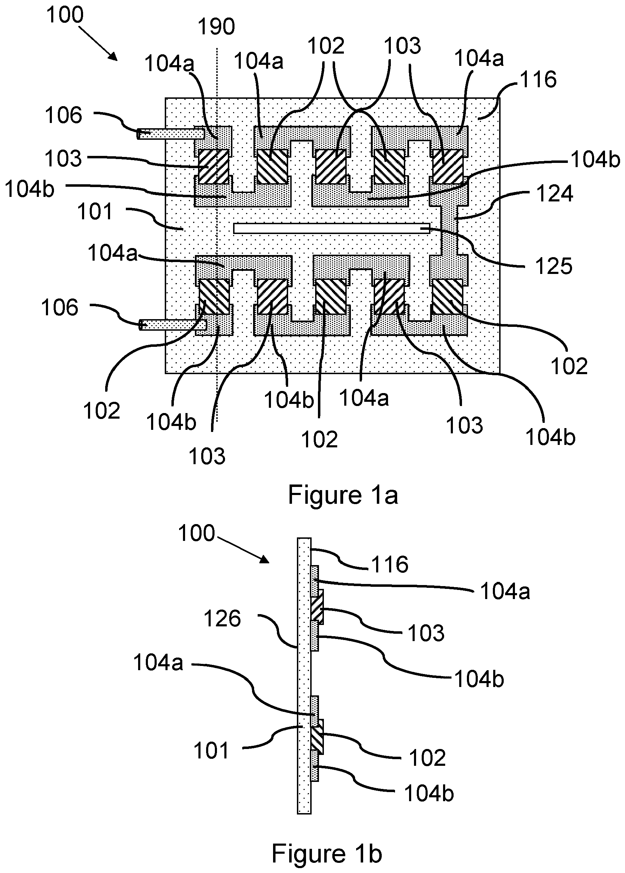

Figure 1a shows a plan view of a net 100 for a thermoelectric module. As will be described herein, the net 100 can be folded along a plurality of fold lines to form a hexagonal network structure for a thermoelectric module.

The net 100 comprises a single electrically insulating flexible substrate 101, alternating n-type thermoelectric elements 102 and p-type thermoelectric elements 103 disposed on a first side 116 of the substrate 101 and electrical interconnects disposed on the first side of the substrate 101. The electrical interconnects include a first plurality of electrical interconnects 104a and a second plurality of electrical interconnects 104b. Each thermoelectric element 102, 103 extends from one of the first plurality of electrical interconnects 104a to one of the second plurality of electrical interconnects 104b. The electrical interconnects 104a, 104b connect the n-type 102 and p-type 103 thermoelectric elements in series, thereby forming a string of electrically-connected thermocouples. The n-type thermoelectric elements 102, p-type thermoelectric elements 103, first and second pluralities of electrical interconnects 104a, 104b are arranged into a plurality of substantially geometrically parallel rows of electrically connected thermoelectric elements 102, 103; an end of each row being electrically connected to an end of an immediately neighbouring row by way of one or more electrical links 124. In Figure 1a, the plurality of substantially parallel rows consists of two rows arranged horizontally.

Two external wires 106 allow external electrical connection. The external wires 106 are each electrically connected to an end of a row of the plurality of substantially parallel rows of thermoelectric elements distal from the electrical link 124.

The substrate 101 has an aperture 125 therethrough. The aperture 125 has the form of a slit extending a distance across a width of the substrate 101.

Figure 1b shows a cross-section of the net 100 along the line 190 (Figure 1a). The n-type 102 and p-type 103 thermoelectric elements and the electrical interconnects 104a, 104b are shown disposed on the first side 116 of the substrate 101. As shown in Figure 1b, the thermoelectric elements 102, 103 may overlap the electrical interconnects 104a, 104b. A second side 126 of the substrate 101, coplanar and opposite the first side 116, may or may not have one or more thermoelectric elements disposed thereon.

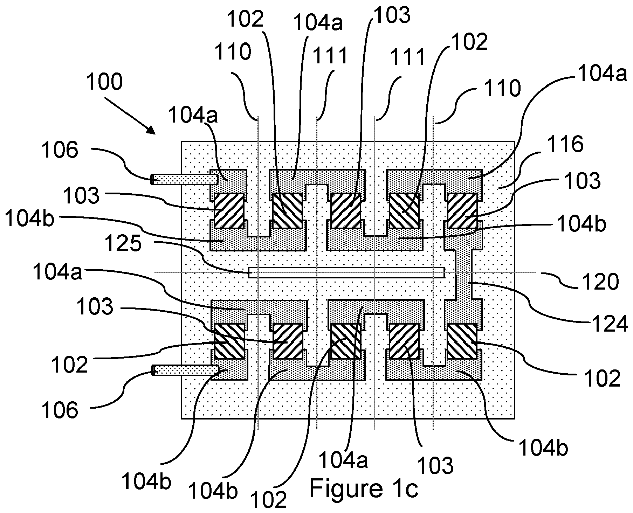

Figure 1c shows the first side 116 of the substrate 101 and indicates the position of a plurality of fold lines 110, 111, 120. These fold lines 110, 111, 120 may take the form of perforations, indentations, or markings on or in the substrate 101, to increase ease of folding. Alternately the fold lines 110, 111, 120 may be virtual lines.

The substrate 101 includes two sets of vertical fold lines: a first set 110 and a second set 111, that are both substantially perpendicular to the rows of thermoelectric elements. In this example, each vertical fold line 110, 111 spans the entire length of the substrate 101. In this example, each member of the vertical fold lines 110, 111 is parallel with the longest edge of the thermoelectric elements 102, 103. The substrate 101 further includes one or more lateral fold lines 120 oriented parallel to the rows of thermoelectric elements and, in this example, perpendicular to the longest edge of the thermoelectric elements 102, 103. Where, as in this example, there are only two rows of elements, only one lateral fold line may be present, positioned along the centreline of the substrate 101. In this example, there are only two fold lines in the first set of fold lines 111 and only two fold lines in the second set of fold lines 110 and the first set of fold lines 111 lies within the second pair of fold lines 110. The vertical fold lines 110, 111 are regularly spaced. The lateral fold line 120 passes through the aperture 125.

After the thermoelectric elements 102, 103 and electrical interconnects 104 have been disposed on the substrate 101, the substrate 101 may then be folded along the fold lines 110, 111, 120 to form a thermoelectric module 1100 (Figure 2a).

The fold lines 110, 111, 120 of the net 100 divide the substrate 101 into a plurality of facets. In general, the one or more fold lines of a net may divide the substrate into two or more facets.

As none of the vertical or lateral fold lines 110, 111, 120 cross a thermoelectric element 102, 103, this may ensure that the structural integrity and adhesion of the generally inflexible thermoelectric elements 102, 103 to the substrate 101 are maintained during folding.

The aperture 125 is configured to facilitate folding of the substrate 101. In general, a net according to this disclosure may have one or more such apertures, which may each take the form of a slit, e.g. a slit that is elongate along a portion of a length of a lateral fold line.

In the illustrated example, the aperture 125 spans the breadth of three neighbouring thermoelectric elements 102, 103 and the electric interconnects 104a, 104b joining in series the three neighbouring thermoelectric elements 102, 103.

Upon folding, facets adjoined by vertical fold lines 110, 111 are offset to one another by a 60-degree angle. The first set of fold lines 110 each indicate a 60-degree valley fold, while the second set of fold lines 111 each indicate a 60-degree mountain fold.

The terms mountain fold and valley fold indicate where a first section of substrate (a first facet) has been folded away from a plane of an adjoining second section (a second facet) by a first angle (for fold lines 110 and 111 this is 60 degrees). These folds create a second angle between the first and second sections of the substrate, measured on the first side of the substrate. Mountain folds are characterised in that the second angle they create is greater than or equal to 180 degrees and less than or equal to 360 degrees. Valley folds are characterised in that the second angle they create is less than 180 degrees and greater than or equal to 0 degrees.

Lateral fold line 120 indicates a 180° mountain fold (i.e., the second angle between the first and second section of the substrate, measured on the first side 116 of the substrate is 360° and the second side 126 of the first section is now coplanar with and facing the second side 126 of the second section). The first 104a and second 104b sets of electrical interconnects cross the vertical fold lines 110, 111 while the electrical link 124 crosses the lateral fold line 120.

Figure 2a shows the thermoelectric module 1100 formed upon folding of the net 100 along the fold lines 110, 111, 120. The fold lines 110, 111, 120 and the aperture 125 are configured such that upon folding, the net forms a hexagonal network structure. Vertical fold lines 110 and 111 shape the facets of the hexagons. As will be explained in more detail further on, this hexagonal shape represents a constituent repeating unit that may be replicated to produce a honeycomb structure.

Figure 2b shows the thermoelectric module 1100 in plan view. The facets 114, 114' include two or more contact facets 114' that, on the second side 126 of the substrate 101, directly contact an adjoining contact facet 114', separated by the lateral fold line 120. Each facet 114, 114' has either one n-type 102 or one p-type 103 thermoelectric element with connecting electrical interconnects 104a, 104b disposed on the first side 116.

The thermoelectric module 1100 comprises all the features of the net 100.

A power source (not shown) may be connected across the external wires 106 such that the thermoelectric module is a thermoelectric heater/cooler.

Alternatively, an energy storage device (not shown) may be connected across the external wires 106 such that the thermoelectric module 100 -thermally connected across a temperature difference- may generate electrical power and act as a thermoelectric generator.

In an implementation, a base edge 170 of the substrate 101, shown in Figure 2a, may be in contact with a solid hot surface (not shown). The remaining edges and surfaces of the substrate 101 may be in contact with cooler air, thus creating a temperature difference across the thermoelectric module 1100. It can therefore be seen that the thermoelectric module 1100 may requires no additional heat sink to thermally couple to the air efficiently. In an example implementation, the thermoelectric elements 102, 103 are positioned such that their longest edge is parallel to the steepest temperature gradient (i.e., the thermoelectric elements 102, 103 are oriented perpendicularly to the base edge 170). In this configuration, current flow through the thermoelectric elements 102, 103 is substantially parallel to the maximum heat flow gradient.

Alternatively, the thermoelectric module 1100 may be used as a thermoelectric generator where the temperature difference is supplied between a solid cold surface in contact with the base edge 170 and the remaining exposed substrate 101 is in contact with warmer air.

The solid hot surface or the solid cold surface may be at least in part flat and/or curved.

The thermoelectric module 1100 may be used as a thermoelectric generator to utilise the temperature difference between two sources of fluid such as one hot and one cold air source.

The thermoelectric module 1100 may be connected to an electronic system (not shown). The electronic system may convert the output of the thermoelectric module 1100 to a stable voltage. The electronic system may enable other functionality such as battery charging, sensor reading or communication.

The substrate 101 may consist of a single sheet of electrically insulating material with low thermal conductivity.

Using a single sheet of substrate 101 which is then folded into a hexagonal pattern is a highly scalable approach, which can be scaled up to produce a larger, tessellating hexagonal shape. An example of this is given in Figure 3 which shows a net 200, which may be folded to form a thermoelectric module 2200 (Figure 4a, Figure 4b) with a tessellating hexagonal shape (otherwise knowns as a honeycomb structure). Such a larger thermoelectric module 2200 can be used to produce more voltage and more electrical power.

As shown in Figure 3, the net 200 has a similar configuration to the net 100. The net 200 comprises a single electrically insulating flexible substrate 201, alternating n-type thermoelectric elements 202 and p-type thermoelectric elements 203 disposed on a first side 216 of the substrate 201 and electrical interconnects 204a, 204b disposed on the first side 216 of the substrate 201. The electrical interconnects include a first plurality of electrical interconnects 204a and a second plurality of electrical interconnects 204b. Each thermoelectric element 202, 203 extends from one of the first plurality of electrical interconnects 204a to one of the second plurality of electrical interconnects 204b. The electrical interconnects 204a, 204b connect the n-type 202 and p-type 203 thermoelectric elements in series, thereby forming a string of electrically connected thermocouples. The n-type thermoelectric elements 202, p-type thermoelectric elements 203, first and second pluralities of electrical interconnects 204a, 204b are arranged into a plurality of substantially parallel rows of electrically connected thermoelectric elements. An end of each row is electrically connected to an end of an immediately neighbouring row by way of an electrical link 224. In Figure 3, the plurality of substantially parallel rows consists of four rows arranged horizontally.

Two external wires 206 allow external electrical connection. The external wires 206 are each electrically connected to an end of a row of the plurality of substantially parallel rows of thermoelectric elements distal from one of the electrical links 224.

The thermoelectric elements 202, 203 may overlap the electrical interconnects 204a, 204b. A second side of the substrate 201, coplanar and opposite the first side 216, may or may not have thermoelectric elements 202, 203 disposed thereon.

Figure 3 shows the first side 216 of the substrate 201 and indicates the position of a plurality of fold lines 210, 211, 220, 221. These fold lines 210, 211, 220, 221 may take the form of perforations, indentations, or markings on or in the substrate 201 to increase ease of folding. Alternatively, the fold lines 210, 211, 220 may be virtual lines.

The substrate 201 includes two sets of vertical fold lines: a first set 210 and a second set 211, that are both substantially perpendicular to the rows of thermoelectric elements.

In this example, each vertical fold line 210, 211 spans the entire length of the substrate 201. Each member of the vertical fold lines 210, 211 is parallel with the longest edge of the thermoelectric elements 202, 203. The substrate 201 further includes a plurality of lateral fold lines 220, 221 oriented parallel to the rows of thermoelectric elements and, in this example, perpendicular to the longest edge of the thermoelectric elements 202, 203. The lateral fold lines include a first set of lateral fold lines 220 and a second set of lateral fold lines 221, the substrate being folded along each of the first set of lateral fold lines 220 to form a 180-degree mountain fold and folded along each of the second set of lateral fold lines 221 to form a 180-degree valley fold. The first set of lateral fold lines 220 and the second set of lateral fold lines 221 alternate along a width of the substrate 201 (substantially perpendicular to the row(s) of thermoelectric elements). In this example, there are only four rows of elements and so only three lateral fold lines are present, one lateral fold line 220, 221 positioned between each row of elements. In the illustrated example, the first set of lateral fold lines 220 includes two lateral fold lines and the second set of lateral fold lines 221 includes one lateral fold line.

After the thermoelectric elements 202, 203 and electrical interconnects 204a, 204b have been disposed on the substrate 201, the substrate 201 is then folded along the fold lines 210, 211, 220, 221 to form a thermoelectric module 2200 (Figure 4a, Figure 4b). The one or more fold lines 210, 211, 220, 221 of the net 200 divide the substrate 201 into two or more facets. As none of the vertical or lateral fold lines 210, 211, 220, 221 cross a thermoelectric element 202, 203, this may ensure that the structural integrity and adhesion of the generally less flexible thermoelectric elements 202, 203 to the substrate 201 is maintained during folding.

The net 200 further includes a plurality of apertures in the substrate 201 to enable folding of the substrate 201. The apertures each take the form of an elongate slit positioned along one of the lateral fold lines 220, 221.

The one or more apertures includes a first set of apertures 225a and a second set of apertures 225b. The first set of apertures 225a and the second set of apertures 225b alternate along a width of the substrate 201 (substantially perpendicular to the row(s) of thermoelectric elements). The first set of apertures 225a and the second set of apertures 225b are substantially similar to the aperture 125 in net 100, each aperture spanning the breadth of three neighbouring thermoelectric elements 202, 203 positioned in a row of the plurality of rows of thermoelectric elements. In the illustrated example, each aperture in the second set of apertures 225b has the same breadth as each aperture in the first set of apertures 225a. The second set of apertures 225b is offset laterally from the first set of apertures 225a by the breadth of two facets (a lateral offset and breadth of the facets being parallel to the lateral fold lines 220, 221). Due to this offset, two apertures in the first set of apertures 225a and an aperture in the second set of apertures 225b extend to an edge of the substrate 201 forming slits extending inwardly from the sides of the substrate 201.

Upon folding, facets adjoined by vertical fold lines 210, 211 are offset from one another by a 60-degree angle. The first set of fold lines 210 indicate 60-degree valley folds, while the second set of fold lines 211 indicate 60-degree mountain folds.

The first set of lateral fold lines 220 indicates a 180-degree mountain fold (i.e., the second angle between the first and second section of the substrate, measured on the first side 216 of the substrate is 360-degrees and the second side of the first section is now coplanar with and facing the second side of the second section). The second set of lateral fold lines 221 indicates a 180-degree valley fold (i.e., the second angle between the first and second section of the substrate, measured on the first side 216 of the substrate is 0-degrees and the first side 216 of the first section is now coplanar with and facing the first side 216 of the second section). The first 204a and second 204b sets of electrical interconnects cross the vertical fold lines 210, 211 while the electrical links 224 each cross one of the lateral fold lines 220, 221.

Figure 4a shows the thermoelectric module 2200 formed upon folding of the net 200 along the fold lines 210, 211, 220, 221. The fold lines 210, 211, 220, 221 and the first and second set of apertures 225a, 225b are configured such that upon folding, the net 200 forms an at least partially open network structure. In this example, the resultant thermoelectric module 2200 has a repeating hexagonal shape. Vertical fold lines 210, 211 shape the facets of the hexagons. This repeating hexagonal shape may represent a constituent repeating unit that may be replicated to produce a tessellating hexagonal (honeycomb) structure or may be scaled up in any suitable way.

Figure 4b shows the thermoelectric module 2200 in plan view. The facets 214, 214' include two or more contact facets 214' that, on either the second side of the substrate, directly contact an adjoining contact facet 214', separated by a lateral fold line 220, 221 of the one or more lateral fold lines 220, 221. Each facet 214, 214' has either one n-type 202 or one p-type 203 thermoelectric element unit with connecting electrical interconnects 204a, 204b disposed on the first side 216.

The contact facets 214' can result in electrically conducting areas at different electrical potentials touching, creating the potential for an undesirable short circuit. To avoid this, the thermoelectric module 2200 may additionally comprise an electrically insulating layer (not shown). The electrically insulating layer contacts and at least partially covers the electrical interconnects 204a, 204b, and/or the thermoelectric elements 102, 103. The electrically insulating layer may directly contact the substrate 201 and may be configured to cover whole or part of the substrate 201. The electrically insulating layer may comprise or essentially consist of an insulating polymer, such as a polyimide or parylene.

Alternatively, the thermoelectric module 2200 may comprise one or more spacers (not shown) each of which forms part of one of the two or more contact facets 214'. Each spacer may be configured to provide a separation between the remainder (i.e., the substrate 201, thermoelectric elements 202, 203 and electrical interconnects) of two adjoining contact facets 214'(separated by a lateral fold line 220).

The thermoelectric module 2200 comprises all the features of the net 200.

The thermoelectric module 2200 may be utilised as a thermoelectric generator or thermoelectric heater/cooler in the same way as explained in relation to thermoelectric module 1100.

By increasing the number of n-type 202 and p-type 203 thermoelectric elements and fold lines in this way, the net 200 can be folded into a number of hexagons in a larger honeycomb structure, forming the thermoelectric module 2200 as depicted in Figure 4a.

By folding the substrate 201 in this way, a thermoelectric module 2200 with a single substrate 201 can be formed into a stable repeating hexagonal pattern. This may eliminate the need for a substrate-to-substrate gluing stage during manufacture, thereby allowing easier and more scalable construction than conventional thermoelectric devices. It should also be noted that if all the fold lines 210, 211, 220, 221 are inverted (i.e., valley folds become mountain folds and mountains folds become valley folds), a similar folded hexagonal thermoelectric module can be created.

The use of folding to create a honeycomb pattern from a single substrate 201 gives significant advantages over alternative folding or rolling techniques. The use of a honeycomb structure allows additional spacing between the thermoelectric elements 202, 203 while maintaining mechanical stability. This increased spacing allows for significantly better thermal coupling between the thermoelectric module 2200 and a surrounding fluid. This improved thermal coupling increases the temperature difference across the thermoelectric elements 202, 203, boosting the power output per thermoelectric material volume. This can result in reduced thermoelectric material costs, while avoiding the extra cost, size and weight of a separate heat sink.

The thermoelectric elements 202, 203 may all be connected electrically in series. This maximises the voltage output. It may however be advantageous to connect some of the thermoelectric elements 202, 203 or some rows of thermoelectric elements in parallel. This may for example make the thermoelectric module 2200 more failure resistant.

Figure 5 shows a plan view of a net 300 for forming a thermoelectric module 3300 (Figure 6). As will be described later, the thermoelectric module 3300 contains features which improve the thermal coupling between the hot or cold fluid and the thermoelectric module 3300. The thermoelectric module 3300 may be formed from the net 300. Alternatively, the thermoelectric module 3300 may be formed in another way.

The net 300 comprises an electrically insulating flexible substrate 301, alternating n-type thermoelectric elements 302 and p-type thermoelectric elements 303 disposed on a first side 316 of the substrate 301 and electrical interconnects disposed on the first side 316 of the substrate 301. The electrical interconnects include a first plurality of electrical interconnects 304a and a second plurality of electrical interconnects 304b. Each thermoelectric element 302, 303 extends from one of the first plurality of electrical interconnects 304a to one of the second plurality of electrical interconnects 304b. The electrical interconnects 304a, 304b connect the n-type 302 and p-type 303 thermoelectric elements in series, thereby forming a string of electrically connected thermocouples.

The n-type thermoelectric elements 302, p-type thermoelectric elements 303, first and second pluralities of electrical interconnects 304a, 304b may be arranged into a plurality of substantially parallel rows of electrically connected thermoelectric elements. An end of each row is electrically connected to an end of an immediately neighbouring row by way of one or more electrical links 324. In Figure 5, the plurality of substantially parallel rows consists of two rows arranged horizontally.

Two external wires 306 allow external electrical connection. The external wires 306 are each electrically connected to an end of a row of the plurality of substantially parallel rows of thermoelectric elements distal from the electrical link 324 associated with that row.

The thermoelectric elements 302, 303 may overlap the electrical interconnects 304a, 304b. A second side 326 (Figure 6) of the substrate 301, coplanar and opposite the first side 316, may or may not have thermoelectric elements 302, 303 disposed thereon.

Figure 5 shows the first side 316 of the substrate 301 and indicates the position of fold lines 310, 311, 320. These fold lines 310, 311, 320 may take the form of perforations, indentations, or markings to the substrate 301 to increase ease of folding. Alternately the fold lines 310, 311, 320 may be virtual lines.

The substrate 301 includes two sets of vertical fold lines: a first set 310 and a second set 311, that are both substantially perpendicular to the rows of elements. In this example, each vertical fold line 310, 311 spans the entire length of the substrate 301. Each member of the sets of vertical fold lines 310 and 311 is parallel with the longest edge of the thermoelectric elements 302, 303. Upon folding, substrate facets adjoined by vertical fold lines 310, 311 are offset to one another by a 60-degree angle. The first set of vertical fold lines 310 indicate 60-degree valley folds, while the second set of vertical fold lines 311 indicate 60-degree mountain folds.

In this example, the thermoelectric module 3300 (Figure 6) comprises a single electrically insulating flexible substrate 301. However, the thermoelectric module 3300 could comprise two or more segments physically connected together. For example, the two or more segments may be physically connected together at regular intervals along the length of the thermoelectric module 3300 to form a partially open network structure.

The segments may be connected together such that at bonding regions of each segment, the first side 316 of each segment is fixed to the second side of an immediately neighbouring segment at one or more bonding regions.

In this way, the two or more segments may be connected together such that the thermoelectric module 3300 comprises one or more hexagons. As such, the thermoelectric module 3300 may have a tessellating hexagonal shape.

The two or more segments may be electrically connected in series and may be positioned substantially antiparallel to one another. Alternatively, the two or more segments may be positioned substantially parallel and electrically connected to one another at both ends of the thermoelectric module 3300 such that the two or more segments are connected in parallel.

In Figure 5, the substrate 301 further includes a lateral fold line 320 oriented parallel to the rows of elements and, in this example, perpendicular to the longest edge of the thermoelectric elements 302, 303. The substrate 301 is folded at the lateral fold line 320 to form a 180-degree mountain fold. In implementations, the net 300 may comprise a first set of lateral fold lines 320, the substrate being folded along each of the first set of lateral fold lines 320 to form a 180-degree mountain fold (i.e., the second angle between the first and second section of the substrate, measured on the first side 316 of the substrate is 360-degrees and the second side of the first section is now coplanar with and facing the second side of the second section). In this example, there are only two rows of thermoelectric elements and so only one lateral fold line 320 is present, positioned between the two rows of thermoelectric elements.

After the thermoelectric elements 302, 303 and electrical interconnects 304a, 304b have been disposed on the substrate 301, the substrate 301 may then be folded along the fold lines 310, 311, 320 to form the thermoelectric module 3300. The one or more fold lines 310, 311, 320 divide the substrate 301 into two or more facets. As none of the vertical or lateral fold lines 310, 311, 320 cross a thermometric element 302, 303, this ensures the structural integrity and adhesion of the generally inflexible thermoelectric elements 302, 203 to the substrate 301 is maintained during folding.

The net 300 includes an aperture 325 in substrate 301 to enable folding of the substrate 301. In this example, the aperture 325 is substantially rectangular in shape and the lateral fold line 320 passes through it. The longer dimension of the aperture 325 is parallel to the lateral fold line 320.

The aperture 325 spans the breadth of three neighbouring thermoelectric elements 302, 303 positioned in a row of the plurality of rows of thermoelectric elements.

The first 304a and second 304b sets of electrical interconnects cross the vertical fold lines 310, 211, while the electrical link 324 crosses the lateral fold line 320.

The thermoelectric module 3300 includes fin structures. The fin structures are provided by the net 300.

One of a first pair of fin structures 307 is formed by elongating one of the second plurality of electrical interconnects 304b in a direction towards the lateral fold line 320. The other of the first pair of fin structures 307 is formed by elongating one of the first plurality of electrical interconnects 304a in a direction towards the lateral fold line 320. The two fin structures of the first pair of fin structures 307 are disposed on opposite sides of the lateral fold line 320. The two fin structures of the first pair of fin structures 307 are equidistant from the lateral fold line 320.

One of a second pair of fin structures 308 is formed by elongating one of the second plurality of electrical interconnects 304b such that it extends a distance along a portion of the substrate 301 protruding into the aperture 325. The other of the second pair of fin structures 308 is formed by elongating one of the first plurality of electrical interconnects 304a such that it extends a distance along a portion of the substrate 301 protruding into the aperture 325. The two fin structures of the second pair of fin structures 308 are offset from each other. The two fin structures of the second pair of fin structures 308 are parallel with each other and there is a gap between the respective portions of the substrate 301 protruding into the aperture 325 that they are disposed on. Each one of the two fin structures of the second pair of fin structures extends more than halfway across the aperture 325.

One of a third pair of fin structures 309 is formed by elongating a broader portion at a first end of the electrical link 324 in a direction towards the lateral fold line 320. The other of the third pair of fin structures 309 is formed by elongating a broader portion at a second end of the electrical link 324 in a direction towards the lateral fold line 320. The two fin structures of the third pair of fin structures 309 are disposed on opposite sides of the lateral fold line 320. The two fin structures of the third pair of fin structures 309 are equidistant from the lateral fold line 320.

The fin structures 307, 308, 309 comprise a thermally conductive material.

The thermally conductive material is thermally coupled to one of the first plurality of electrical interconnects 304a or one of the second plurality of electrical interconnects 304b.

In an assembled thermoelectric module such as the thermoelectric module 3300, since adjacent facets are connected by thermally conductive interconnects 304a, 304b, the increased surface area of the fin structures 307, 308, 309 could still benefit all facets even if not present on all facets, e.g. if only present on alternate facets.

Specific fin structure configurations discussed in this disclosure are not intended to be considered as limiting and any combination of these configurations is considered within the scope of this disclosure.

Adding fin structures 307, 308, 309 increases the total substrate area per thermoelectric element, thus increasing the substrate cost. To reduce the substrate cost, it is advantageous to maximise the fractional coverage of the thermally conductive material pieces on the elongate portions of substrate.

The fin structures 307, 308, 309 may be made of the same material as the electrical link 324 and/or the electrical interconnects 304a, 304b.

It will be apparent to those skilled in the art that the thermoelectric module 3300 may be scaled up in much the same way as discussed in relation to thermoelectric module 1100. Namely, the one or more lateral fold lines 320 including a second set of lateral fold lines, the substrate 301 being folded along each of the second set of lateral fold lines to form a 180-degree valley fold. The first set of lateral fold lines 320 and the second set of lateral fold lines alternating along a width of the substrate 301 (substantially perpendicular to the row(s) of thermoelectric elements). The second set of lateral fold lines indicating a 180-degree valley fold (i.e., the second angle between the first and second section of the substrate, measured on the first side 316 of the substrate is 0-degrees and the first side 316 of the first section is now coplanar with and facing the first side 316 of the second section). To enable scaling up, the one or more apertures 325a may include a second set of apertures. The first set of apertures 325a and the second set of apertures alternating along a width of the substrate 301 (substantially perpendicular to the row(s) of thermoelectric elements). Each aperture in the second set of apertures having the same breadth as each aperture in the first set of apertures 325a. The second set of apertures being offset laterally from the first set of apertures 325a by the breadth of two facets (a lateral offset and breadth of the facets being parallel to the lateral fold lines 320). Due to this offset, some apertures in the second set of apertures may extend beyond the edge of the substrate 301 forming holes in the sides of the substrate 301.

By increasing the number of n-type 302 and p-type 303 thermoelectric elements and fold lines in this way, the net can be folded into a number of hexagons in a larger honeycomb structure, with a stable repeating hexagonal pattern, thereby forming a larger thermoelectric module (not shown). This may eliminate the need for a substrate-to-substrate gluing stage during manufacture allowing easier and more scalable construction than conventional thermoelectric devices. It should also be noted that if all the fold lines 310, 311, 320 are inverted (i.e., valley folds become mountain folds and mountains folds become valley folds), a similar folded hexagonal thermoelectric module can be created.

Figure 6 shows the thermoelectric module 3300 . The substrate 301 consists of a single sheet of material folded along the fold lines 310, 311, 320 to form an at least partially open network structure.

The fold lines 310, 311, 320 and the aperture 325 are configured such that upon folding, the thermoelectric module 3300 is formed in the shape of an at least partially open network structure, in this example, a hexagonal shape. Vertical fold lines 310, 311 shape the facets of the hexagons. This hexagonal shape represents a constituent repeating unit that may be replicated to produce a tessellating hexagonal (honeycomb) structure as described in relation to thermoelectric modules 1100 and 2200.

Figure 6 shows the fin structures 307, 308, 309 extending beyond the other facets of the hexagon. This may increase the thermal coupling between the thermoelectric module 3300 and the air, increasing the temperature difference across the thermoelectric elements 302, 303 and improving power generation performance.

The electrical interconnects 304a, 304b and adjoining fin structures 307, 308, 309 are made of a material with high thermal conductivity. Hence, there is good heat transfer along the fin structures 307, 308, 309. Simulation suggests that in some configurations, addition of these fin structures 307, 308, 309 can double the power output of each thermoelectric element 302, 303.

The thermoelectric module 3300 may be utilised as a thermoelectric generator or thermoelectric heater/cooler in the same way as explained in relation to thermoelectric module 1100.

The thermoelectric elements 302, 303 may all be connected electrically in series. This maximises the voltage output. It may however be advantageous to connect some of the thermoelectric elements 302, 303 or some rows of thermoelectric elements in parallel. This may for example make the thermoelectric module 3300 more failure resistant.

Figure 7a shows a plan view of a net 500 for forming a thermoelectric module 5500 (Figure 8). Figure 7b shows a magnified view of a central portion of the net 500. As will be described later, the thermoelectric module 5500 contains features which improve the thermal coupling between the hot or cold fluid and the thermoelectric module 5500. The thermoelectric module 5500 may be formed from the net 500. Alternatively, the thermoelectric module 5500 may be formed in another way.

When considering a thermoelectric device as disclosed herein, e.g. the thermoelectric module 2200 shown in Figure 4a, it may be advantageous to increase the voltage output, for example to enable easy integration with an electronic system. The output voltage can be increased by increasing the number of hexagonal units and thus the module size. Alternatively, the voltage may be increased by decreasing the width of each of the thermoelectric elements 202, 203 (perpendicular to the current) as this would allow for a reduced facet size, increasing the number of facets 214 and therefore hexagons within a fixed thermoelectric module size. However, there is a lower limit on the width of the thermoelectric elements 202, 203 driven by the maximum resolution of the deposition of the thermoelectric elements 202, 203 and the required width to form folds at the fold lines 210, 211, 220. In addition, were fins such as those described in relation to the thermoelectric module 3300 of the thermoelectric module 5500 to be implemented, then the use of smaller facets would change the spacing between the fins, possibly impeding airflow and thus good thermal coupling between the module and the air. In light of these considerations, it may be advantageous to position multiple thermoelectric elements on each facet of a hexagon, between each fold line.

A way of introducing multiple thermoelectric elements on a single facet may be to use both sides of the substrate, with one thermoelectric element on each side. This decreases the quantity of substrate required per thermoelectric element, so can additionally reduce cost. In an embodiment, all of the n-type thermoelectric elements may be on one side of the substrate and all the p-type thermoelectric elements may be disposed on the other side, as this can reduce any cross contamination and enable easier deposition.

An example of such a configuration can be seen in Figures 9a, 9b, 9c and 10. Figure 9a shows a plan view of a first side a net 700 for forming a thermoelectric module 7700 (Figure 10). Figure 9b shows a plan view of a second side of the net 700, the second side being opposite the first side. Figure 9c shows a cross-section of the net 700 through a line 790 (Figure 9a).

Referring to Figures 9a, 9b and 9c, the net 700 comprises an electrically insulating flexible substrate 701. The substrate 701 has a first side 716 (Figure 9a, Figure 9c) and a second side 726 (Figure 9b, Figure 9c).

On the first side 716 of the substrate 701 are disposed a first p-type thermoelectric element 703a, a second p-type thermoelectric element 703b, a third p-type thermoelectric element 703c, a fourth p-type thermoelectric element 703d, a fifth p-type thermoelectric element 703e, a sixth p-type thermoelectric element 703f, a seventh p-type thermoelectric element 703g, an eighth p-type thermoelectric element 703h and a ninth p-type thermoelectric element 703i. The p-type thermoelectric elements 703a, 703b, 703c, 703d, 703e, 703f, 703g, 703h, 703i are arranged in two rows, a first row including the first p-type thermoelectric element 703a, the second p-type thermoelectric element 703b, the third p-type thermoelectric element 703c, the fourth p-type thermoelectric element 703d and the fifth p-type thermoelectric element 703e and a second row including the sixth p-type thermoelectric element 703f, the seventh p-type thermoelectric element 703g, the eighth p-type thermoelectric element 703h and the ninth p-type thermoelectric element 703i.

On the second side 726 of the substrate 701 are disposed a first n-type thermoelectric element 702a, a second n-type thermoelectric element 702b, a third n-type thermoelectric element 702c, a fourth n-type thermoelectric element 702d, a fifth n-type thermoelectric element 702e, a sixth n-type thermoelectric element 702f, a seventh n-type thermoelectric element 702g, an eighth n-type thermoelectric element 702h and a ninth n-type thermoelectric element 702i. The n-type thermoelectric elements 702a, 702b, 702c, 702d, 702e, 702f, 702g, 702h, 702i are arranged in two rows, a first row including the first n-type thermoelectric element 702a, the second n-type thermoelectric element 702b, the third n-type thermoelectric element 702c and the fourth n-type thermoelectric element 702d and a second row including the fifth n-type thermoelectric element 702e, the sixth n-type thermoelectric element 702f, the seventh n-type thermoelectric element 702g, the eighth n-type thermoelectric element 702h and the ninth n-type thermoelectric element 702i.

As will be described in more detail below, the p-type thermoelectric elements 703a, 703b, 703c, 703d, 703e, 703f, 703g, 703h, 703i and the n-type thermoelectric elements 702a, 702b, 702c, 702d, 702e, 702f, 702g, 702h, 702i are electrically connected in a series-connected string made up of alternating p-type thermoelectric elements 703a, 703b, 703c, 703d, 703e, 703f, 703g, 703h, 703i and n-type thermoelectric elements 702a, 702b, 702c, 702d, 702e, 702f, 702g, 702h, 702i. Two external wires 706 connected to each end of the series-connected string allow electrical connection to the net 700.

A first end interconnect 741 is disposed on the first side 716 of the substrate 701 and provides an electrical connection from one of the external wires 706 to a first end of the first p-type thermoelectric element 703a. A first electrical interconnect 704a provides an electrical connection from a second end of the first p-type thermoelectric element 703a to a first end of the first n-type thermoelectric element 702a. A second electrical interconnect 704b provides an electrical connection from a second end of the first n-type thermoelectric element 702a to a first end of the second p-type thermoelectric element 703b. A third electrical interconnect 704c provides an electrical connection from a second end of the second p-type thermoelectric element 703b to a first end of the second n-type thermoelectric element 702b. A fourth electrical interconnect 704d provides an electrical connection from a second end of the second n-type thermoelectric element 702b to a first end of the third p-type thermoelectric element 703c. A fifth electrical interconnect 704e provides an electrical connection from a second end of the third p-type thermoelectric element 703c to a first end of the third n-type thermoelectric element 702c. A sixth electrical interconnect 704f provides an electrical connection from a second end of the third n-type thermoelectric element 702c to a first end of the fourth p-type thermoelectric element 703d. A seventh electrical interconnect 704g provides an electrical connection from a second end of the fourth p-type thermoelectric element 703d to a first end of the fourth n-type thermoelectric element 702d. An eighth electrical interconnect 704h provides an electrical connection from a second end of the fourth n-type thermoelectric element 702d to a first end of the fifth p-type thermoelectric element 703e. A ninth electrical interconnect 704i provides an electrical connection from a second end of the fifth p-type thermoelectric element 703e to a first end of the fifth n-type thermoelectric element 702e. A tenth electrical interconnect 704j provides an electrical connection from a second end of the fifth n-type thermoelectric element 702e to a first end of the sixth p-type thermoelectric element 703f. An eleventh electrical interconnect 704k provides an electrical connection from a second end of the sixth p-type thermoelectric element 703f to a first end of the sixth n-type thermoelectric element 702f. A twelfth electrical interconnect 704l provides an electrical connection from a second end of the sixth n-type thermoelectric element 702f to a first end of the seventh p-type thermoelectric element 703g. A thirteenth electrical interconnect 704m provides an electrical connection from a second end of the seventh p-type thermoelectric element 703g to a first end of the seventh n-type thermoelectric element 702g. A fourteenth electrical interconnect 704n provides an electrical connection from the second end of the seventh n-type thermoelectric element 702g to a first end of the eighth p-type thermoelectric element 703h. A fifteenth electrical interconnect 704o provides an electrical connection from the second end of the eighth p-type thermoelectric element 703h to a first end of the eighth n-type thermoelectric element 702h. A sixteenth electrical interconnect 704p provides an electrical connection from the second end of the eighth n-type thermoelectric element 702h to a first end of the ninth p-type thermoelectric element 703i. A seventeenth electrical interconnect 704q provides an electrical connection from the second end of the ninth p-type thermoelectric element 703i to a first end of the ninth n-type thermoelectric element 702i. A second end interconnect 742 provides an electrical connection from the second end of the ninth n-type thermoelectric element 702i to the other of the external wires 706.

Each one of the electrical interconnects 704, 704b, 704c, 704d, 704e, 704f, 704g, 704h, 704i, 704j, 704k, 704l, 704m, 704n, 704o, 704p, 704q includes a first portion on the first side 716 or the second side 726 of the substrate 701 and a second portion on the other of the first side 716 or the second side 726 of the substrate 701. An intermediate portion connects the first portion to the second portion. The intermediate portion of each one of the electrical interconnects 704, 704b, 704c, 704d, 704e, 704f, 704g, 704h, 704i, 704j, 704k, 704l, 704m, 704n, 704o, 704p, 704q extends through a respective one of a plurality of apertures 782 through the thickness of the substrate 701. For clarity, not all of the apertures 782 are labelled in Figures 9a, 9b and 9c.

In the illustrated example, the second end interconnect 742 includes a first portion on the second side 726 of the substrate 701 and a second portion on the first side 716 of the substrate 701. An intermediate portion connects the first portion to the second portion. The intermediate portion of the second end interconnect 742 extends through an aperture 782 through the thickness of the substrate 701. The other of the external wires 706 is connected to the second portion of the second end interconnect 742.

The substrate 701 has an aperture 725 therethrough. The aperture 725 has the form of a slit extending a distance across a width of the substrate 701. When looking at the first side 716 of the substrate 701, the aperture 725 is disposed between the first row of p-type thermoelectric elements and the second row of p-type thermoelectric elements. Figure 9c shows a cross-section of the net 700 through the line 790 (Figure 9a).

Figure 9a shows the first side 716 of the substrate 701 and indicates the position of a plurality of fold lines 710, 711, 720. These fold lines 710, 711, 720 may take the form of perforations, indentations, or markings on or in the substrate 701, to increase ease of folding. Alternately the fold lines 710, 711, 720 may be virtual lines.

The substrate 701 includes two sets of vertical fold lines: a first set 710 and a second set 711, that are both substantially perpendicular to the rows of thermoelectric elements. In this example, each vertical fold line 710, 711 spans the entire length of the substrate 701. Each member of the vertical fold lines 710, 711 is parallel with the longest edge of the thermoelectric elements. The substrate 701 further includes one or more lateral fold lines 720 oriented parallel to the rows of thermoelectric elements and, in this example, perpendicular to the longest edge of the thermoelectric elements. Where, as in this example, there are only two rows of thermoelectric elements on each side of the substrate, only one lateral fold line may be present, positioned along the centreline of the substrate 701. In this example, there are only two fold lines in the first set of fold lines 711 and only two fold lines in the second set of fold lines 710 and the first set of fold lines 711 lies within the second pair of fold lines 710. The vertical fold lines 710, 711 are regularly spaced. The lateral fold line 720 passes through the aperture 725.

The first portion of ninth electrical interconnect 704i includes an electrical link 724 extending across the lateral fold line 720.

After the thermoelectric elements and the electrical interconnects have been disposed on the substrate 701, the substrate 701 may then be folded along the fold lines 710, 711, 720 to form the thermoelectric module 7700 (Figure 10).

The fold lines 710, 711, 720 of the net 700 divide the substrate 701 into a plurality of facets. In general, the one or more fold lines of a net may divide the substrate into two or more facets.

As none of the vertical or lateral fold lines 710, 711, 720 cross a thermoelectric element, this may ensure that the structural integrity and adhesion of the generally inflexible thermoelectric elements to the substrate 701 are maintained during folding.

The aperture 725 is configured to facilitate folding of the substrate 701. In general, a net according to this disclosure may have one or more such apertures, which may each take the form of a slit, e.g. a slit that is elongate along a portion of a length of a lateral fold line.

In the illustrated example, the aperture 725 spans the breadth of three neighbouring thermoelectric elements.

Upon folding, facets adjoined by vertical fold lines 710, 711 are offset to one another by a 60-degree angle. The first set of fold lines 710 each indicate a 60-degree valley fold, while the second set of fold lines 711 each indicate a 60-degree mountain fold.

The terms mountain fold and valley fold indicate where a first section of substrate (a first facet) has been folded away from a plane of an adjoining second section (a second facet) by a first angle (for fold lines 710 and 711 this is 60 degrees). These folds create a second angle between the first and second sections of the substrate, measured on the first side of the substrate. Mountain folds are characterised in that the second angle they create is greater than or equal to 180 degrees and less than or equal to 360 degrees. Valley folds are characterised in that the second angle they create is less than 180 degrees and greater than or equal to 0 degrees.

Lateral fold line 720 indicates a 180° mountain fold (i.e., the second angle between the first and second section of the substrate, measured on the first side 716 of the substrate is 360° and the second side 726 of the first section is now coplanar with and facing the second side 726 of the second section).

In this example, the thermoelectric module 7700 (Figure 10) comprises a single electrically insulating flexible substrate 701. However, the thermoelectric module 7700 could comprise two or more segments physically connected together. For example, the two or more segments may be physically connected together at regular intervals along the length of the thermoelectric module 7700 to form a partially open network structure.

The segments may be connected together such that at bonding regions of each segment, the first side of each segment is fixed to the second side of an immediately neighbouring segment at bonding regions.

In this way, the two or more segments 740 may be connected together such that the thermoelectric module 7700 comprises one or more hexagons. As such, the thermoelectric module 7700 may have a tessellating hexagonal shape.

The two or more segments may be electrically connected in series and may be positioned substantially antiparallel to one another. Alternately, the two or more segments may be positioned substantially parallel and electrically connected to one another at both ends of the thermoelectric module 7700 such that the two or more segments are connected in parallel.

After the thermoelectric elements 702, 703 and electrical interconnects 704 have been disposed on the substrate 701, the substrate 701 may then be folded along the fold lines 710, 711, 720 to form the thermoelectric module 7700. As none of the vertical or lateral fold lines 710, 711, 720 cross a thermoelectric element 702, 703, this ensures the structural integrity and adhesion of the generally less flexible thermoelectric elements 702, 703 to the substrate 701 is maintained during folding.

It will be apparent to those skilled in the art that the thermoelectric module 7700 may be scaled up in the same way as discussed, for example, in relation to the thermoelectric module 1100.

In general, the interconnects that cross fold lines will be a mixture of concave and convex bends of the electrical interconnect on the substrate. Concave bends are preferred as they reduce the likelihood of cracking and resistance increases for the interconnects. In an embodiment of the disclosure, a combination of through holes and interconnects may be used to enable all the interconnects that cross fold lines to be bent in a concave manner.

The use of both sides of the substrate of the substrate 701 may be combined with the fin structures to combine the benefits previously discussed in relation to each of these features. An additional advantage of this combined approach would be that all the electrical interconnects that cross a 60-degree fold line can be formed on the air side of the thermoelectric module, improving heat spreading between facets without fins and facets with fin structures, offering a small power increase.

The thermoelectric module 7700 may be utilised as a thermoelectric generator or thermoelectric heater/cooler in the same ways as explained, for example, in relation to the thermoelectric module 1100.

It is within the scope of the present disclosure for an array or arrangement of multiple thermoelectric modules to be electrically connected together in a variety of configurations.

A thermal interface material may be added between a bottom of a thermoelectric module according to this disclosure, e.g. the thermoelectric module 1100, the thermoelectric module 2200, the thermoelectric module 3300, the thermoelectric module 5500 or the thermoelectric module 7700, and a solid hot or cold surface. The thermal interface material may be in the form of a setting or curing thermal interface material to provide thermal coupling between the solid surface and the thermoelectric module and to secure it in place.

A number of features may be added to enable easier folding of a net according to the disclosure. Easier folding may reduce the substrate space required for the fold and minimise any undesired bending or distortion of thermoelectric elements that may damage the thermoelectric elements. These features may include but are not limited to holes, slits or slots in the substrate or scoring of the substrate. Electrical interconnects that cross fold lines may be made narrower and/or thinner as they cross the fold line.

Folds may be made mechanically, for example by hand or in an automated process. Folds may be made by forming the bends over a rod, bar or plate which has the appropriate curvature or shape to form the bend. The radius of curvature of the substrate at the fold lines may be at least 0.05 mm or at least 0.5 mm and/or up to 2.5 mm or up to 5 mm.

The substrate may comprise, or consist essentially of, a polymeric material, such as polyimide, polyethylene terephthalate or other plastics. An example of a suitable polyimide film is Kapton^{®}, manufactured by DuPont. The substrate thickness may be at least 1 micron or at least 10 microns and/or up to 100 microns or up to 1 mm to balance between foldability, mechanical sturdiness, and any thermal shunting within the thermoelectric module.

The n-type and p-type thermoelectric elements may comprise organic, inorganic materials or composites of both. Thermoelectric material choice may be a balance between thermoelectric performance, cost, ease of deposition and robustness or flexibility. Thermoelectric materials may include PEDOT for p-type and poly nickel-ethenetetrathiolates (Nax(Ni-ett)n) for n-type material. These materials may provide an advantage in flexibility. Thermoelectric materials for the thermoelectric elements may include but are not limited to: bismuth telluride; bismuth selenide; antimony telluride; PANI, P3HT, carbon nanotubes, graphene, nanosheets or nanorods and combinations of the above. The thermoelectric materials may also include any suitable combination of dopants and/or other additives that may alter the chemical composition and/or thermoelectric properties. Either or both the n-type and p-type thermoelectric materials may be doped, for example with carbon nanotubes in different forms such as powder and veil.

It is advantageous for the electrical interconnects to be formed from a material with a high electrical and thermal conductivity to reduce electrical and thermal losses. The electrical interconnects may therefore be made from metal such as copper, silver, nickel, aluminium or gold. It may be advantageous to deposit a number of layers of the electrical interconnects to improve electrical contact to the thermoelectric elements. As such, the electrical interconnects may include a number of layers such as copper, nickel, and gold. In the interest of cost or simplicity of processing, the electrical interconnects may be made of the n or p-type thermoelectric material itself. Interconnects may be applied by electrolytic or electroless plating, or by printing and sintering. The thickness of the electrical interconnects is a balance between improving electrical and thermal conduction at higher thicknesses and improving the ease of folding at lower thicknesses. Electrical interconnects may have a thickness of at least 100 nanometre or at least 1 micron and/or up to 100 microns or up to 1 millimetre.

The thickness of the thermoelectric elements may be selected to suit individual applications. Thinner thermoelectric elements tend to be more flexible, and exhibit increased thermal resistance, improving the temperature difference across the thermoelectric elements and therefore improving the voltage output. Thicker layers decrease the electrical resistance, increasing the current output. The thicknesses of the thermoelectric elements may be in the range 10 nanometre to 1 millimetre. The thickness of the thermoelectric elements may be in the range 100 nanometre to 500 microns. The thickness of the thermoelectric elements may be in the range 1 micron to 100 microns.

The width of each of the thermoelectric elements, measured perpendicular to the direction of current within the thermoelectric element, is linked to the size of the facets and the desired voltage and current balance from the module. The width of the thermoelectric elements may be at least 0.1 mm, at least 1 mm and/or up to 10 mm or up to 20 mm.

The length of the thermoelectric elements, measured parallel to the direction of current within the thermoelectric element, is a balance between minimising the electrical resistance of the thermoelectric elements (maximising the current output) and maximising their thermal resistance (maximising their voltage output). The length of the thermoelectric elements may be in at least 0.1 mm, at least 0.5 mm and/or up to 10 mm or up to 20 mm.

The widths and lengths of the n-type and p-type thermoelectric elements may differ to accommodate different material properties of the two materials.

Figure 11a to 11d show a part of a net 900 for a thermoelectric module. The net 900 comprises an electrically insulating flexible substrate 901. Alternating n-type thermoelectric elements 902 and p-type thermoelectric elements 903 are disposed on a first side 916 of the substrate 901. Each thermoelectric element 902, 903 extends from one of a first plurality of electrical interconnects 904a to one of a second plurality of electrical interconnects 904b. The electrical interconnects 904a, 904b connect he n-type 902 and the p-type 903 thermoelectric elements in series, thereby forming a string of electrically-connected thermocouples.

A plurality of bending strips 980 are applied to the net 900. As can be seen in Figure 11b, each bending strip 980 may be disposed on at least one electrical interconnect 904a, 904b and may extend across a fold line, e.g. a fold line 910.

The bending strips 980 are configured to react to a stimulus 970 (Figure 11d) by changing shape, thereby causing the substrate 901 to fold along the fold lines. The bending strips 980 may be positioned where necessary to cause the substrate 901 to fold in a desired manner to form a thermoelectric module.

The bending strips 980 may comprise, or consist essentially of, any suitable material and the stimulus 970 may be any one of: a temperature change (heating or cooling), light, UV light, voltage, exposure to ozone. In this example, the bending strips 980 may comprise, or consist essentially of, bi-stretched polystyrene film (b-PS) and the stimulus 970 is a temperature increase of the bending strip 980.

As shown in Figure 11d the stimulus 970 causes a conformation change in the bending strips 980 which in turn actuates folding of the substrate 901 along the fold line 910. In this way, the net 900 may be self-folding at least in part, in the illustrated example creating a 60-degree valley fold. Figure 11d illustrates the folding that occurs when the thermoelectric module bending strips 980 are heated from 20°C to 130°C.

In this example, the bending strips 980 are disposed on a first side 916 of the substrate 901 along with the n-type and p-type thermoelectric elements 902, 903. However, it will be understood that bending strips may alternately be disposed only on a second side of the substrate 901 or be disposed on both the first 916 and second sides of the substrate 901, as required.

The stimulus 970 applied to the bending strips 980 may trigger folding at all fold lines simultaneously or in sequence to rapidly form a thermoelectric module.

In some implementations, the bending strips 980 may be secured in place by any suitable means, e.g. a mechanical fastening means, an adhesive or lamination.

The bending strips 980 may undergo an irreversible dimensional change upon application of the stimulus 970. For example, strips of bi-stretched polystyrene film (b-PS) shrink irreversibly upon heating. The b-PS film may be attached to the substrate 901 using an adhesive such as a cyanoacrylate glue. As the contraction of the b-PS film is significantly larger than any dimensional change of the substrate 901 and the electrical interconnect 904a, 904b upon heating, this causes the substrate 901 to fold. The fold is constrained to the region around the fold line 910 as the larger area of the stiffer interconnects 904a, 904b on the facets restricts bending in these regions. By appropriate choice of the thickness, width and length of the b-PS bending strips, the required angle (60 or 180 degrees) of folding may be achieved. It may be advantageous to only add the bending strips over the interconnects 904a, 904b and substrate 901 so as to avoid any detrimental interaction with the thermoelectric elements 902, 903. The or each bending strip, prior to application of the stimulus 970, may have a thickness of at least 0.01 mm, at least 0.1 mm and/or up to 0.5 mm or up to 1 mm.

Self-folding of the thermoelectric module may alternatively be achieved by making the substrate itself irreversibly change dimensions upon application of an external trigger.

Figure 12 shows schematically a method 1000 of manufacture or assembly of a thermoelectric module.

The method 1000 comprises a first step 1001 of providing a net according to the present disclosure, e.g. the net 100, the net 200, the net 300, the net 500, the net 700 or the net 900.

A second step 1002 includes forming one or more valley folds in the net, along the or a first set of vertical fold lines.

A third step 1003 involves forming one or more mountain folds in the net along the or a second set of vertical fold lines.

A fourth step 1005 involves forming one or more further mountain folds or valley folds in the net along the lateral fold line(s).

The method 1000 may additionally comprise one or more of a first preliminary step 1006, a second preliminary step 1007 and a third preliminary step 1008.

The first preliminary step 1006 may include depositing the electrical interconnects on the substrate.

The second preliminary step 1007 may include depositing the n-type and p-type thermoelectric elements on the substrate.

The thermoelectric elements may be deposited using a number of thick and thin film methods. Thermoelectric materials may be applied on the substrate with different techniques including but not limited to electroplating, chemical vapor deposition, physical vapor deposition, thermal evaporation, sputtering, spray deposition, screen or stencil printing, doctor blade or by using an adhesive and/or mechanical fastening.

The second preliminary step 1007 may compromise multiple steps to dispose the thermoelectric elements on to the substrate. This may include printing the thermoelectric elements on to the substrate. At least one thermoelectric element may be printed onto the substrate. The thermoelectric element(s) may be heated after printing to improve the performance of the thermoelectric material. Other types of thermoelectric element may be physically attached to the substrate during the second preliminary step 1007.

The third preliminary step 1008 may include encapsulating one or more of the thermoelectric elements or the net with an outer electrically insulating layer. Such a layer may be made of a polyimide such as Kapton^{®}, nylon or another polymeric material. It is advantageous that the encapsulating material has a low thermal conductivity to reduce thermal shunting. The encapsulating layer may be attached using adhesives, lamination or other mechanical means. The enclosure formed by the encapsulating layer might be water tight and/or air tight. The enclosure may protect the thermoelectric element(s) from mechanical stress which is applied during folding, from contamination or degradation by external factors, and may help to avoid electrical shunting between different parts of the module if the module is deformed.

Alternatively or in addition, the third preliminary step 1008 may include depositing one or more spacers on to the thermoelectric module.

Where the third preliminary step is completed, it may be completed after the first and/or second preliminary steps have been completed.

Each of the preliminary steps may be completed prior to the other steps of the method 1000 or as part of the first step 1001 of the method 1000. The steps may be completed according to their numbered order i.e., with the first step preceding the second step etc., or in any other suitable order. For example, the second preliminary step may be completed before the first preliminary step is completed.

The embodiments discussed in this disclosure are intended as specific examples and are not meant as limiting. Any and all features discussed in this disclosure may be used in combination with any other features discussed in this disclosure, within the scope as defined in the claims.

## Claims

1. A net for a thermoelectric module, the net comprising:
an electrically insulating substrate;
a plurality of thermoelectric elements disposed on the substrate, the plurality of thermoelectric elements comprising one or more n-type thermoelectric elements and one or more p-type thermoelectric elements; and
one or more electrical interconnects disposed on the substrate, each electrical interconnect providing an electrical connection between a first thermoelectric element and a second thermoelectric element, wherein the first thermoelectric element is one of an n-type or a p-type thermoelectric element and the second thermoelectric element is the other of an n-type or a p-type thermoelectric element;
wherein the substrate comprises a single sheet of material with one or more fold lines extending at least partially across the substrate, wherein the one or more fold lines are arranged such that folding the substrate along the one or more fold lines forms an at least partially open network structure.

2. The net of claim 1, wherein the at least partially open network structure has one or more cells and/or wherein the at least partially open network structure comprises a honeycomb or hexagonal pattern.

3. The net of claim 1 or claim 2, wherein the substrate comprises at least one aperture therethrough, the aperture(s) being arranged to facilitate folding of the substrate.

4. The net of any one of the preceding claims comprising one or more fin structures comprising a thermally conductive material, optionally wherein at least one of the fin structures comprises a portion of the substrate with the thermally conductive material disposed thereon.

5. The net of claim 4, wherein any one or more of:
a) at least one of the fin structures is/are configured such that the fin structure(s) is/are disposed at least partially within a cell of the at least partially open network structure when the substrate is folded along the one or more fold lines;
b) one or more of the fin structures comprise an extended portion of an electrical interconnect; and/or
c) when the net is unfolded, one or more of the fin structures lie within the or an aperture.

6. The net of any one of the preceding claims, wherein one or more of the thermoelectric elements are disposed on a first side of the substrate and one or more of the thermoelectric elements are disposed on a second side of the substrate opposite the first side of the substrate, and optionally:
wherein one or more of the electrical interconnects include: a first portion on the first side or the second side of the substrate; a second portion on the other of the first side or the second side of the substrate; and an intermediate portion connecting the first portion to the second portion, and further optionally:
wherein the intermediate portion passes through the thickness of the substrate.

7. The net of any one of the preceding claims comprising at least one bending strip extending across at least one of the fold lines, wherein the bending strip(s) is/are configured to change conformation in response to a stimulus, thereby causing the substrate to fold.

8. A thermoelectric module comprising:
an electrically insulating substrate;
a plurality of thermoelectric elements disposed on the substrate, the plurality of thermoelectric elements comprising one or more n-type thermoelectric elements and one or more p-type thermoelectric elements; and
one or more electrical interconnects disposed on the substrate, each electrical interconnect providing an electrical connection between a first thermoelectric element and a second thermoelectric element, wherein the first thermoelectric element is one of an n-type or a p-type thermoelectric element and the second thermoelectric element is the other of an n-type or a p-type thermoelectric element;
wherein the substrate comprises a single sheet of material with one or more fold lines extending at least partially across the substrate and the substrate is folded along the one or more fold lines to provide an at least partially open network structure.

9. The thermoelectric module of claim 8, wherein one or both of:
a) the at least partially open network structure has one or more cells and/or wherein the at least partially open network structure comprises a honeycomb or hexagonal pattern; and/or
b) the thermoelectric module comprises at least one bending strip extending across at least one of the fold lines.

10. The thermoelectric module of claim 8 or claim 9 comprising one or more fin structures comprising a thermally conductive material, optionally wherein at least one of the fin structures comprise a portion of the substrate with the thermally conductive material disposed thereon.

11. The thermoelectric module of claim 10, wherein one or both of:
a) at least one of the fin structures is/are disposed at least partially within a cell of the at least partially open network structure; and/or
b) one or more of the fin structures comprise an extended portion of an electrical interconnect and/or wherein at least one of the fin structures extend in a direction away from a base edge of the substrate.

12. The thermoelectric module of any one of claims 8 to 11, wherein one or more of the thermoelectric elements are disposed on a first side of the substrate and one or more of the thermoelectric elements are disposed on a second side of the substrate opposite the first side of the substrate, and optionally:
wherein one or more of the electrical interconnects include: a first portion on the first side or the second side of the substrate; a second portion on the other of the first side or the second side of the substrate; and an intermediate portion connecting the first portion to the second portion, and further optionally:
wherein the intermediate portion passes through the thickness of the substrate.

13. A thermoelectric device comprising at least one thermoelectric module according to any one of claims 8 to 12, and wherein optionally the thermoelectric device comprises a thermoelectric generator or a thermoelectric cooler or heater.

14. A method of manufacture or assembly of a thermoelectric module comprising:
providing a net according to any one of claims 1 to 7; and
folding the substrate along the one or more fold lines to form an at least partially open network structure, and optionally:
wherein folding the substrate along the one or more fold lines comprises applying a stimulus to one or more bending strips extending across at least one of the fold lines, wherein the bending strip is configured to change conformation in response to the stimulus.

15. Use of a thermoelectric device according to claim 13 to:
a) generate electricity; or
b) provide cooling or heating.
